Europäisches Patentamt

European Patent Office

Office européen des brevets

(11) Publication number: **0 364 215**
**A2**

## EUROPEAN PATENT APPLICATION

(21) Application number: 89310354.9

(51) Int. Cl.5: **H01J 37/32**

(22) Date of filing: **10.10.89**

(30) Priority: **11.10.88 JP 255541/88**

(43) Date of publication of application:
**18.04.90 Bulletin 90/16**

(84) Designated Contracting States:
**DE FR GB**

(71) Applicant: **ANELVA CORPORATION**
**8-1 Yotsuya 5-chome**
**Fuchu-shi Tokyo 183(JP)**

(72) Inventor: **Tsukada, Tsutomu c/o Anelva Corp.**
**8-1 Yotsuya 5-chome**
**Fuchu-shi 183 Tokyo(JP)**
Inventor: **Asamaki, Tatsuo c/o Anelva Corp.**
**8-1 Yotsuya 5-chome**
**Fuchu-shi 183 Tokyo(JP)**

(74) Representative: **Crisp, David Norman et al**
**D. YOUNG & CO. 10 Staple Inn**
**London, WC1V 7RD(GB)**

(54) **Plasma etching apparatus.**

(57) A plasma etching apparatus comprising a treatment chamber (8) capable of being evacuated, an electrode structure comprising first and second electrodes (4 and 6) which face each other in the treatment chamber and a gas introducing means (2) provided in connection with the first electrode, and a radiofrequency power source (7) connected to the electrode structure for supplying radiofrequency electric power to a space between the gas introducing means and the second electrode. The gas introducing means comprises a graphite panel (22) having a silicide layer (23) formed at least on the surface of graphite facing the second electrode and has a large number of through-holes (3) for passing therethrough a gas fed to a space between the first electrode and the introducing means into the space between the gas introducing means and the second electrode.

*FIG. 1*

## Plasma Etching Apparatus

The present invention relates to a plasma etching apparatus having an electrode structure for introducing thereinto a gas for forming a plasma.

Examples of materials used for gas introducing means or parts thereof in plasma etching apparatus for introducing a gas into a space between facing electrodes via either one of the electrodes which have been proposed include aluminum, stainless steel, graphite, glassy or vitreous carbon, porous sintered quartz, sintered alumina, and sintered silicon carbide. Where use is made of a gas introducing part made of aluminum, stainless steel or a similar material and having a large number of mechanically formed through-holes, the aluminum, nickel and other components of the stainless steel, or similar materials may be sputtered, thus presenting various problems including contamination therewith of an object to be treated, formation of a reaction product which remains on the object, and deterioration in the electrical characteristics of the object. Where use is made of a gas introducing part made of vitreous carbon and having a large number of mechanically formed through-holes, a problem arises that microcrystals may be formed from the vitreous carbon by any thermal shock accompanying the sputtering thereof which can then adhere to an object, thus contaminating the object. Where use is made of a gas introducing part made of graphite, there is a problem that part of the graphite may exfoliate and then cling to an object to contaminate the object. Where use is made of a gas introducing part comprising a porous quartz sinter, there is a problem that the porous quartz sinter may itself be etched when a silicon dioxide film is etched.

The above-mentioned porous quartz sinter also has a low strength, due to the number of pores therein. A large number of holes is required in order to secure a necessary gas flow rate therethrough, for example, of about 300 cc/min with a pressure difference of 0.5 to 1 kg.f/cm$^2$ as in the case of dry etching, and in view of the fact that the pore diameter of the porous quartz sinter is as small as 90 to 3,000 Å. Furthermore, the process of preparing the porous quartz sinter is problematic since the pore diameter and the number of pores cannot be controlled as desired because a glass powder more or less uniform in particle size is sintered to prepare the porous quartz sinter.

The thickness of the porous quartz sinter is usually desired to be at most about 3mm. This is because electric power supplied for producing a plasma is reduced to a degree which corresponds to the thickness of the porous quartz sinter since the porous quartz sinter when inserted between electrodes acts as a dielectric. Accordingly, the production of an at most 3mm thick high-strength porous quartz sinter part large enough to cover a normal sized electrode having a diameter of 150 to 220mm is very difficult from the viewpoint of the strength of the sinter. In addition, the quartz sinter having pores as fine as 90 to at most 3,000 Å in diameter is also problematic in that various reaction products formed by a reaction of a gaseous plasma, for example, when an SiO$_2$ film is etched, are deposited in and around the gas ejecting pores of the quartz sinter clogging the pores or make gas introduction non-uniform, resulting in non-uniform etching.

An aluminum (Al$_2$O$_3$) sinter is problematic not only in that the sinter lowers the plasma formation efficiency because of the large dielectric loss when a radiofrequency electric power is applied to the electrodes between which the sinter is disposed, but also in that the sinter acts as a contamination source releasing alumina or aluminum formed through decomposition thereof when a surface of the sinter exposed to a plasma is sputtered.

In contrast, a silicon carbide sinter, when high in purity, allows etching to be carried out without substantial contamination of an object to be treated. However, a silicon carbide sinter gas introducing part is gradually etched on the side in contact with the plasma during plasma etching. Therefore, as several thousand silicon dioxide films may be etched using the apparatus, the distance between the gas introducing part adjacent to one electrode and its counter electrode eventually differs between a point at the middle portion of an object to be etched and a point at the peripheral portion of the object. This leads to a slowing down of the etching rate and exacerbation of non-uniform etching rate distribution. Thus, replacement of an old silicon carbide sinter with a new one is repeatedly required. However, high purity silicon carbide sinters can be very expensive and replacement greatly increases the running cost of etching apparatus. The use of silicon carbide is uneconomical. This makes it difficult to use high-purity silicon carbide sinters on a scale of mass production.

Furthermore, in the case of the silicon carbide sinter, an electrically conductive substance must be adhered to the inner side of the sinter, i.e. between the sinter and one electrode, in order to improve the electrical connection therebetween and thereby enhance the plasma density. The operation of adhering the electrically conductive substance to the sinter requires further labour and is uneconomical.

We have now found it possible to solve the foregoing problems of the prior art to thereby provide a plasma etching apparatus capable of formng a stable and high-density plasma.

According to the present invention, there is provided a plasma etching apparatus comprising a treatment chamber capable of being evacuated, an electrode structure comprising first and second electrodes which face each other in said treatment chamber, a gas introducing means provided in association with said first electrode, and a radiofrequency power source connected to said electrode structure for supplying radiofrequency electric power to a space between said gas introducing means and said second electrode, wherein said gas introducing means comprises a graphite panel having a silicide layer formed at least on the surface of the graphite facing said second electrode and further comprises a large number of through-holes for passing therethrough a gas fed into a space between said first electrode and said introducing means and into the space between said gas introducing means and said second electrode.

In the plasma etching apparatus of the present invention, etching can be effected with little contamination of the object, while the electrical conductivity of the graphite panel is utilized to improve the efficiency of forming the plasma. Another advantage is that the use of a graphite panel is economical.

Preferred features and embodiments of the invention will now be described by way of non-limiting example with reference to the accompanying drawings, in which:

Fig. 1 is a schematic side view of an embodiment of plasma etching apparatus of the present invention;

Fig. 2 is a schematic side view of another embodiment of plasma etching apparatus of the present invention; and

Figs. 3(a) and 3(b) are enlarged schematic cross-sectional views showing partial structures of embodiments of a gas introducing part used in the plasma etching apparatus of the present invention.

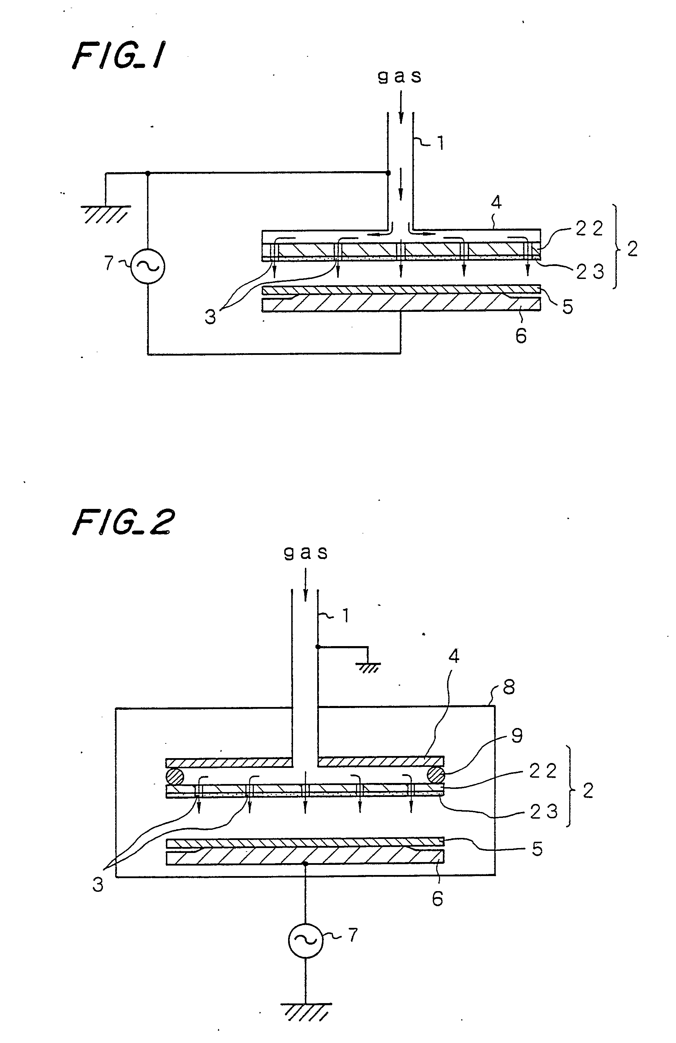

The structure of Fig. 1 comprises: a gas pipe 1 through which a gas can be introduced into the apparatus; a gas introducing means or part 2 comprising a graphite panel 22 having a silicide layer 23 formed on the surface of graphite by surface silification; first and second electrodes 4 and 6 for forming a plasma discharge; an object 5 to be treated by ion etching or the like; and a radiofrequency power source 7. The gas introducing part 2 is integrated with the first electrode 4 to form an integrated electrode.

The gas introducing part 2 shown in Fig. 1 which comprises the graphite panel 22 having the silicide layer 23 formed on the surface of graphite is used to introduce a gas, fed through the gas pipe 1, into a space between the gas introducing part 2 and the second electrode 6, through holes 3 in the gas introducing part 2. The gas fed through the gas pipe 1 and introduced into the space between the gas introducing part 2 and the second electrode 6 via the gas introducing part 2 is turned into a plasma through a discharge produced using radiofrequency electric power supplied to the space between the gas introducing part 2 and the second electrode 6 by a radiofrequency power source 7. The object 5 placed on the second electrode 6 can be plasma-etched with the above-mentioned plasma.

As shown in Fig. 1, the gas fed through the gas pipe 1 is blown uniformly against the object 5 via the gas introducing part 2; this is a further advantage of the present invention. Since the graphite panel 22, having the silicide layer 23 formed on the surface of graphite through surface silicification is used as the gas introducing part 2 through which the gas is blown against the object 5, the gas introducing part 2, even when exposed to the plasma, does not act as a contamination source of a metal such as aluminum, while almost all of the reaction products, particularly when using a fluorine-containing gas, are volatile and are not deposited on the object 5. Furthermore, the silicified surface of the graphite panel prevents the object 5 from being contaminated with graphite particles or the like. Moreover, the gas introducing part 2 comprising the surface-silicified graphite panel 22 causes little electric power loss by virtue of its own electrical conductivity and allows a stable and high-density plasma to be efficiently formed.

Fig. 2 is a side view of the structure of an embodiment of the plasma etching apparatus of the present invention. The structure of Fig. 2 comprises a treatment chamber 8, an electrode ring 9 mainly for achieving electrical connection of a gas introducing part 2 with a first electrode 4. The other parts numbered 1 to 7 respectively correspond to those shown with the same reference numerals in Fig. 1.

In the structure of Fig. 2, gas fed through a gas pipe 1 is spread through a space defined by the first electrode 4, the gas introducing part 2 and the electrode ring 9. The gas passing through the gas introducing part 2, comprising a graphite panel 22 having a silicide layer 23 formed on the surface of graphite by surface silicification, is passed through the holes 3 onto an object 5 placed on a second electrode 6, while at the same time radiofrequency electric power generated with a radiofrequency power source 7 is applied to a space between the gas introducing part 2 and the second electrode 6 to form a plasma in the space, with which the object 5 can be plasma-etched.

The silicide layer of the above-mentioned graphite panel 23 is not formed at least on the area of the panel in contact with the electrode ring 9 to secure electrical connection of the graphite panel with the first electrode 4, but at least covers the whole surface of graphite facing the second electrode 6.

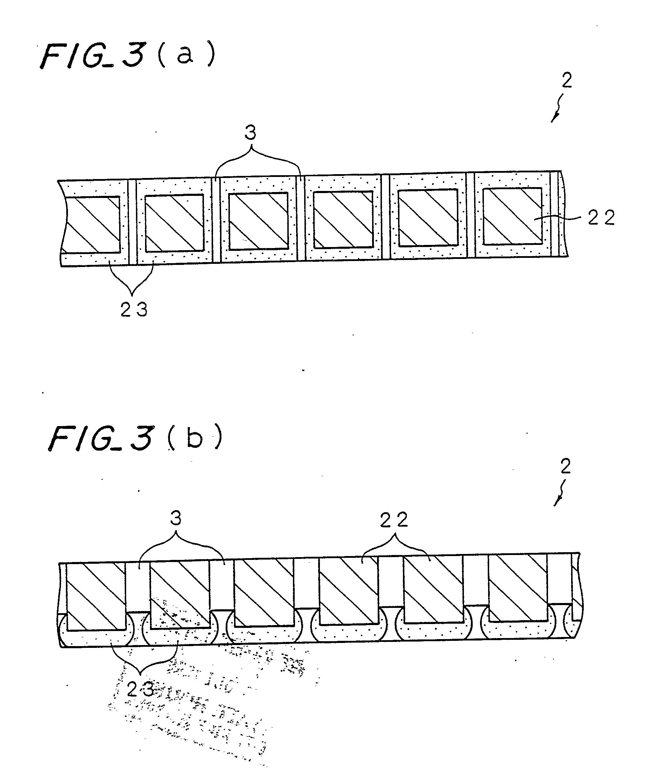

Figs. 3(a) and 3(b) show embodiments of partial structures of the gas introducing part 2 having formed therethrough holes 3. The structure shown by Fig. 3(a) is obtained by making a large number of holes through the graphite panel 22 and then forming a silicide layer 23 on the whole surface of graphite by means of a surface silicification process. Thus, the silicide layer 23 covers the inner wall of the holes 3. On the other hand, the structure shown by Fig. 3(b) is obtained by making a large number of holes through the graphite panel 22 and then depositing the silicide layer 23 on the surface of the panel 22 facing, for example, the second electrode 6 by means of a chemical vapor deposition method. Thus, the silicide layer 23 shown in Fig. 3(b) covers the surface of the panel 22 facing the second electrode 6 and a portion of the inner wall of the respective holes 3.

The use of the graphite panel having the silicide layer 23, formed on the surface of graphite panel 22 through surface silicification, as the gas introducing part 2 is effective in preventing the object 5 from being contaminated and in efficiently forming the plasma. The gas introducing part 2 is gradually etched on the side in contact with the plasma causing a change in the distance between the gas introducing part 2 and the second electrode 6. As a result, non-uniform etching rate distribution is exacerbated simultaneously with the lowering of the etching rate. Accordingly, the gas introducing part 2 must be replaced with a new one after etching several thousand objects. However, the use of surface-silicified graphite panels as the gas introducing part 2 is very economical. The price of each surface-silicified graphite panel 22 can be as low as 1/10 that of a silicon carbide sinter. As for etching characteristics, the use of the surface silicified graphite panel 22 is comparable to the use of the silicon carbide sinter. Furthermore, since the surface-silicified graphite panel 22 has a high electrical conductivity, the use of the surface-silicified graphite panel 22 can improve the etching rate by 10 to 20% over the use of the silicon carbide sinter even if no electrically conductive substance is provided between the graphite panel and the first electrode.

The silicide layer of, for example, about 1mm in thickness, formed on the surface of graphite through surface silicification, prevents the object from being contaminated with graphite particles, even if the silicide layer is considerably etched to a thickness of about 0.8mm.

In the present invention, a choice of about 0.1 to about. 0.5mm for the diameter of gas-ejecting-through holes in the graphite panel means that strong discharge hardly occurs around the through-holes, while an arrangement of the through-holes at suitable intervals enables the gas to be uniformly passed therethrough.

As described above, the silicification of the about 1mm thick surface portion of a graphite panel makes the graphite panel resistant to etching, as compared with quartz and anodized aluminum, and well resistant from for example, a plasma formed from a fluorine-containing gas, such as $CF_4$ or $CHF_3$, which is used when an $SiO_2$ film is etched. This makes uniform etching possible. Furthermore, since the surface-silicified graphite panel has a very high thermal conductivity as compared with alumina and silicon carbide, it can particularly be advantageously used as a gas ejecting panel having a surface exposed to a plasma and heated by the plasma.

A preferred process for silicifying a surface portion of a graphite panel comprises heating a processed graphite panel in an atmosphere of SiO gas at a high temperature of at least 800°C to form a silicide layer of about 1mm in thickness on the surface of the remaining graphite. Alternatively, a silicon carbide film may be deposited on the surface of a graphite panel by a CVD method.

According to the present invention, since a graphite panel having a silicide layer formed on the surface of graphite, which is attached to an electrode, is used as a gas introducing part for introducing therethrough a gas into a space between the gas introducing part and another facing electrode, the etching operation can be carried out without contamination of an object while utilizing the electrical conductivity of the graphite panel to form a stable and high-density plasma.

## Claims

1. A plasma etching apparatus comprising a treatment chamber (8) capable of being evacuated, an electrode structure comprising first and second electrodes (4 and 6) which face each other in said treatment chamber, a gas introducing means (2) provided in association with said first electrode, and a radiofrequency power source (7) connected to said electrode structure for supplying radiofrequency electric power to a space between said gas introducing means and said second electrode, wherein said gas introducing means comprises a graphite panel (22) having a silicide layer (23) formed at least on the surface of the graphite facing said second electrode and further comprises a large number of through-holes (3) for passing therethrough a gas fed into a space between said first electrode and said introducing means and into the space between said gas introducing means and said second electrode.

2. A plasma etching apparatus as claimed in claim 1, wherein said first electrode is integral with said gas introducing means and an electrode ring (9) is provided therebetween.

3. A plasma etching apparatus as claimed in claim 1 or 2, wherein said silicide layer is a silicon carbide layer.

4. A plasma etching apparatus as claimed in any preceding claim, wherein said graphite panel has through-holes of 0.1 to 0.5mm diameter.

5. A plasma etching apparatus as claimed in any preceding claim wherein a plasma is produced from the gas passed into the space between said gas introducing means and said second electrode, through the through-holes of said gas introducing means, using the radiofrequency electric power in order to effect therewith plasma-etching of an object (5) which is placed on the surface of said second electrode facing said first electrode.

6. A method for plasma-etching an object using an apparatus according to any one of claims 1 to 5.

7. A plasma-etched object produced using an apparatus according to any one of claims 1 to 5.

8. Use of an apparatus according to any one of claims 1 to 5 for plasma-etching an object.

FIG_1

FIG_2

*FIG_3* ( a )

2

3

22

23

*FIG_3* ( b )

2

3

22

23